# EUROPEAN PATENT APPLICATION

(11) **EP 4 454 838 A1**
(43) Date of publication of application: **30.10.2024**
(21) Application number: 24173029.0
(22) Date of filing: 29.04.2024
(51) Int. Cl.: B25J 19/00, H01R 12/61

(54) **ROBOT AND WIRING STRUCTURE FOR ROBOT**

(30) Priority: 28.04.2023 JP 2023074633
(71) Applicant: DENSO WAVE INCORPORATED, Chita-gun, Aichi-pref. 470-2297 (JP)
(72) Inventor: TANADA, Mizuki, Chita-gun, Aichi-pref., 470-2297 (JP)
(74) Representative: Winter, Brandl - Partnerschaft mbB

(57) **Abstract**

In a wiring structure for a robot (15), an FPC board (45) has a conductor layer (72) provided as a wiring pattern arranged between a base layer (71) and a cover layer (73). The FPC board (45) has a one end part at which the conductor layer (72) is exposed outside from the cover layer (73), a connection part (45b) being arranged on the one end part and being connected to a connector (42) of a further electric component of the robot (15). A compensating layer (74) arranged on the connection part (45b) compensates for a thickness of the FPC board (45) and is partially inserted into an insertion slot (43) of the connector (42). The compensating layer (74) is formed to bridge a thickness step (BP) provided between portions of the conductor layer (72) which are covered by the cover layer and is exposed, and has a protruding portion protruded from the insertion slot (43). A restrictive member (68) provided on the protruding portion is allowed to touch the compensating layer (74) such that the FPC board (45) is restricted from being deformed.

## Description

### Background

### [Technical Field]

The present invention relates to a robot and a wiring structure for the robot, and in particular, to a robot with an articulated arm and a robot wiring structure applied to such an articulated arm.

### [Related Art]

Robots, including industrial robots, are currently used in a wide variety of types of places. One of the types of robots is an articulated robot with a robot arm (manipulator) with bendable joints. In the case of articulated robots, cables are used to transmit and receive control signals to and from the controller as well as to supply power to motors installed at the joints of the robot for drive the joins. Recently, a technology using a flexible printed circuit board (referred to as FPC board) as such a cable has been proposed (see, for example, Patent Document 1). This flexible printed circuit boards are highly flexible and bendable. Thus, by using the flexible printed circuit board, positional coexistence with components placed around devices such as motors can be made easier in the robot's joints. It can also contribute to high-density mounting of various components and miniaturization of the robot's joints.

### [Prior Art Reference]

### [Patent Documents]

[Patent Reference 1] JP-A-2010-214528

### [Problems to be solved]

When the flexible printed circuit board is used as the cables, the structural design must take into account the insertion and removal of its connectors and other connection parts. As an example, it is necessary to secure a certain amount of extra length in the flexible printed circuit board. Securing the extra length is also desirable to improve workability for assembling. However, a large bending reaction force (or stress) may be generated in the flexible printed circuit board when the extra length portion is processed. In the flexible printed circuit board, as an example, a coverlay film layer is provided to cover the conductor layer that forms the wiring patterns, and apertures and the like are formed in this coverlay film layer. These openings expose a portion of the wiring pattern to the outside.

In such a configuration, the thickness of the flexible printed circuit board becomes discontinuous at the edges (thickness step) of the aperture, and the bending reaction force generated when processing the extra length portion tends to concentrate in this area during the assembly process. Excessive concentration of such stress can cause disconnection of the wiring pattern near the thickness step, resulting in loss of communication function and/or power transmission function. Thus, it is desired to suppress the disconnection of a robot equipped with flexible printed circuit boards when the flexible printed circuit boards are assembled. Therefore, there is still room for improvement in the wiring structure in order to increase the reliability of the robot.

### Summary

The present invention has been made in view of the above-mentioned problems, and its main purpose is to reduce, in the assembly of the flexible printed circuit boards in manufacturing robots such as industrial robots, occurrence of wire breakage or connection failure during assembly of the flexible printed circuit board, thereby improving the reliability of an articulated robot.

The following is a description of the means to solve the above issues.

In order to solve the foregoing issues, as an exemplary embodiment, there is provided a wiring structure for a robot (15) provided with a base layer (71), a cover layer (73), and a flexible printed circuit board (45) having a conductor layer (72) provided as a wiring pattern arranged between the base layer (71) and the cover layer (73).

In this configuration, the flexible printed circuit board (45) has a one end part at which the conductor layer (72) is exposed outside from the cover layer (73), a connection part (45b) being arranged on the one end part and being connected to a connector (42) of a further electric component of the robot (15).

A compensating layer (74) is arranged on the connection part (45b), the compensating layer (74) being subjected to compensation for a thickness of the flexible printed circuit board (45), the compensating layer (74) being provided on a part of the base layer which is faced to the conductor layer, the connection part (45b) being partially inserted into an insertion slot (43) of the connector (42).

The compensating layer (74) is formed to bridge a thickness step (BP) provided between a portion at which the conductor layer (72) is covered by the cover layer (73) and a portion at which the conductor layer (72) is exposed from the cover layer (73) and to partially protrude from the insertion slot (43) when the connection part (45b) of the flexible printed circuit board (45) is inserted into the insertion slot (43) to electrically connect the connection part (45b) and the connector (42).

In addition, the compensating layer (74) has a protruding portion protruded from the insertion slot (43). A restrictive member (68) is provided on the protruding portion to overlap with the compensating layer (74) in a thickness direction (T) of the flexible printed circuit board (45), the restrictive member (68) being allowed to touch the compensating layer (74) such that the flexible printed circuit board (45) is prohibited or restricted from being deformed.

In the configuration shown in the first means, the thickness of the flexible printed circuit board is discontinuous at the thickness step between the portion where the conductor layer is covered by the cover layer and the portion where the conductor layer is exposed from the cover layer. The degree of deformation may increase locally at the discontinuity in thickness. This is because stress concentration occurs due to the lower strength of the board.

However, in the present exemplary embodiment, a compensating layer for the connector is formed across this thickness step. The compensating layer increases the thickness of the flexible printed circuit board and reduces deformation near the thickness step.

However, even the part where the compensating layer is formed may be deformed by strong force applied during the assembly process of the flexible printed circuit board. When such deformation occurs, the deformation near the thickness step may be larger than that of other parts.

Hence, the compensating layer is formed so that the compensating layer protrudes from the insertion slot of the connector. Additionally to this protruded configuration, a restrictive member is provided at the position overlapping this protruding portion. When the flexible printed circuit board is deformed (e.g., bent) and hits the restrictive member, further deformation is restricted or prohibited by the restrictive member. Therefore, disconnection at the foregoing thickness step, i.e., loss of electrical communication function due to disconnection, can be reduced. This allows the robot to enjoy the benefits of using flexible printed circuit boards (e.g., high-density mounting of various electrical components and miniaturization of the robot) while contributing to improved reliability of the robot.

### Brief Description of the Drawings

In the accompanying drawings;
Fig. 1 is a perspective view showing a robot system employing an industrial robot, which is according a first embodiment of the present disclosure;
Fig. 2 is a block diagram showing the electrical configuration of the robot system;
Fig. 3 is a plan view shoeing a motor unit and a configuration around hereof, which are installed in each of the joints of a robot arm;
Fig. 4 is a perspective view showing a board unit and a flexible printed circuit board;
Fig. 5A is a partial sectional view cut along an A-A line in Fig. 3;
Fig. 5B is a partial sectional view cut along a B-B line in Fig. 3;
Fig. 6 is a partial side view outlining a flexible printed circuit board;
Fig. 7A is a side view outlining a comparative example;
Fig. 7B is a side view outlining how the flexible printed circuit board is restricted from being deformed excessively;
Fig. 8 is a flowchart explaining a procedure for assembling the flexible printed circuit board;
Figs. 9A to 9C respectively show a part of the procedure for assembling the flexible printed circuit board;
Fig. 10A is a flowchart explaining a procedure for assembling a flexible printed circuit board according to a modification;
Fig. 10B is a partial sectional side view explaining how the flexible printed circuit board is restricted from being deformed excessively;
Fig. 11A is a partial sectional side view explaining how the flexible printed circuit board is restricted from being deformed excessively; and
Fig. 11B is a partial sectional side view explaining how the flexible printed circuit board is restricted from being deformed excessively.

### Descriptions of the Preferred Embodiments

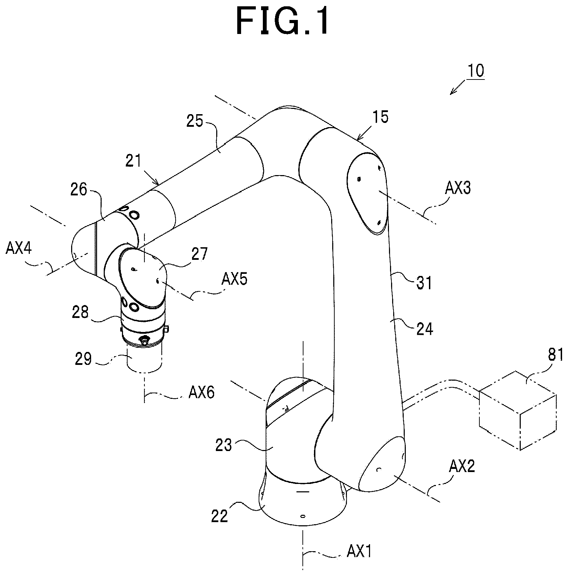

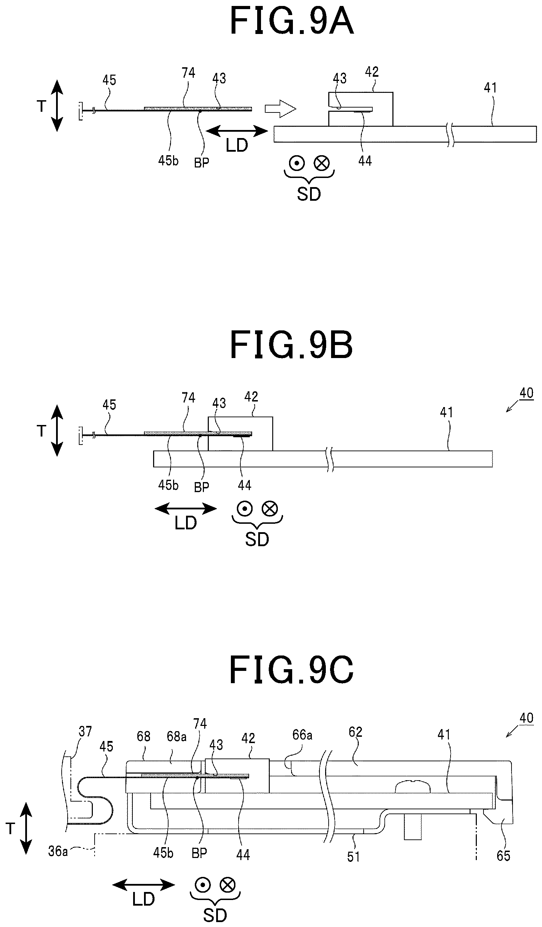

With reference to Figs. 1 - 9A, 9B, and 9C, there is provided an embodiment of a robot system 10 provided with an industrial robot 15 (hereinafter, simply referred to a robot 15). The industrial robot is provided as a vertically articulated industrial robot which engages in work on a factory production line or other sites.

As shown in Fig. 1, the robot has a main body (i.e., robot body 21) including a base member 22 fixed to a pedestal or the like, a shoulder member 23 supported by the base member 22, a lower arm member 24 supported by the shoulder member 23, a first upper arm member 25 supported by the lower arm member 24, a second upper arm member 26 supported by the first upper arm member 25, a wrist member 27 supported by the second upper arm member 26, and a flange 28 supported by the wrist member 27.

The base member 22 and the shoulder member 23 have a first joint member mutually rotatably connecting both the base member 22 and the shoulder member 23. Hence, the shoulder member 23 can rotate horizontally around a connection axis (a first axis AX1) of the first joint member. The shoulder member 23 and lower arm member 24 have a second joint member that mutually rotatably connects the shoulder member 23 and lower arm member 24. Hence, the lower arm member 24 can rotate vertically about a connection axis (a second axis AX2) of the second joint member.

The lower arm member 24 and the first upper arm member 25 have a third joint member that mutually rotatably connects the lower arm member 24 and the first upper arm member 25. Hence, the first upper arm member 25 is rotatable in a vertical direction around the connection axis (a third axis AX3) of the third joint. The first upper arm member 25 and the second upper arm member 26 have a fourth joint member that mutually rotatably connects the first upper arm member 25 and the second upper arm member 26. Hence, the second upper arm member 26 is rotatable in the twisting direction around a connection axis (a fourth axis AX4) of the fourth joint member. The second upper arm member 26 and wrist member 27 have a fifth joint member that mutually rotatably connects the second upper arm member 26 and wrist member 27. Hence, the wrist member 27 is rotatable in the vertical direction around a connection axis (a fifth axis AX5) of the fifth joint member. The wrist member 27 and the flange 28 have a sixth joint member that mutually rotatably connects the wrist member 27 and the flange 28. Hence, the flange 28 can be rotated in a twisting direction around a connection axis (a sixth axis AX6) of the sixth joint member.

The shoulder member 23, the lower arm member 24, the first upper arm member 25, the second upper arm member 26, the wrist member 27, and the flange 28 are thus connected in series to form a single arm or manipulator, where these members constitute the arm 31 of the robot body 21. An end effector 29 is attached to the flange 28 at the end of the arm 31. For example, the end effector 29 is provided as a hand type end effector (or a gripper) which can grasp workpieces under controlling motions of the robot 15.

As will be described in detail later, a motor unit is provided for each of the joint members on the arm 31. This motor unit has a servo motor serving as an electric actuator that rotates the joint, a reduction gear (specifically, a wave gear unit) attached to the servo motor, and a motor control board (servo amplifier) that controls the drive of the servo motor.

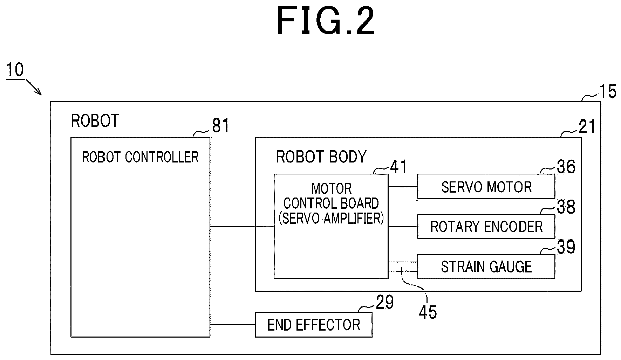

Here is a supplementary explanation of the electrical configuration of the robot system 10 with reference to Fig. 2.

The robot system 10 has a robot controller 81 serving as a general controller, to which the motor control board 41 described above are each connected. The servo motor 36 and rotary encoder 38 are connected to the motor control board 41, which receives work operation instructions from the robot controller 81 and identifies operation target positions. The servo motor 36 is then driven and controlled based on the motion target positions and position data obtained from the rotary encoder 38, i.e., the encoder values indicating the rotation angles (rotation positions) of the servo motor 36.

The robot 15 (in other words, each of the motor units 35) is provided with a torque detection sensor that detects the torque generated at the joints. The torque detection sensor has a plurality of strain gauges 39 arranged in the foregoing reduction gear and detection sections connected to each of the strain gauges 39 via lead wires. The detection sections each has a bridge circuit section (e.g., Wheatstone bridge), which is an electric circuit suitable for detecting minute changes in resistances, and an amplifier section for amplifying each of the signals detected by the bridge circuit sections. The amplified signals are transmitted to the motor control boards 41 mounted in the motor units 35. The motor control board 41 is configured to decelerate or stop (including protective stop) motions of the robot 15 according to the signals (detected torques) from the torque detection sensors. This improves the safety of the robot system 10.

As described above, the motor unit 35 is composed of various components including the servo motor 36 and reduction gear, and is miniaturized by closely arranging the various components in the space. In order to improve the safety of the robot system 10 by using the torque detection sensor described above, it is important that the torque detection sensor, servo motor 36, reduction gear 37, and the other components can coexist well in the limited space. In consideration of this situation, in the present embodiment, as pictorially illustrated in Fig. 2, the strain gauge 39 is connected to a motor control board 41, which is a rigid board, via a flexible printed circuit board (hereinafter referred to as an FPC board 45) that has a thin and strip-shaped form.

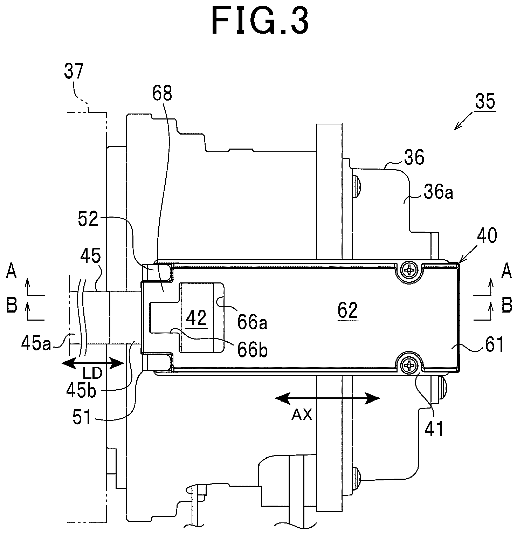

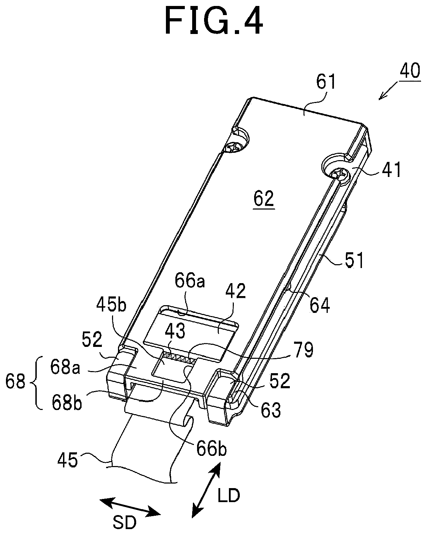

As shown in Figs. 3 and 4, the FPC board 45 has one end (i.e., the one end in the longitudinal direction LD of the FPC board 45). This one end serves as a connection part to the reduction gear 37 and, in detail, to the above-mentioned strain gauge 39 (hereinafter also referred to as a gauge-side connection part 45a), which is located on the flexible gear. The FPC board 45 has the other end (other end in the longitudinal direction LD). This other end functions as a connection part to the motor control board 41, more specifically, to the connector 42 provided on the motor control board 41 (hereinafter also referred to as a control-board-side connection part 45b).

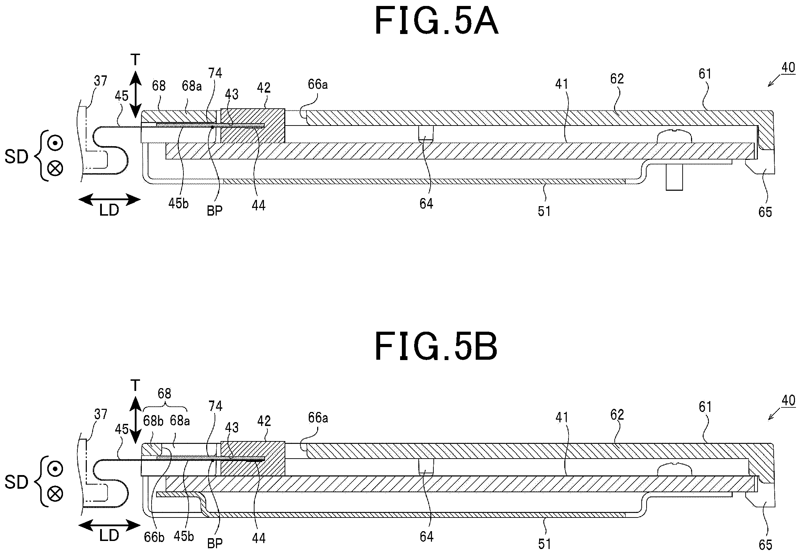

As shown in Figs. 4 and 5, the motor control board 41 has a long board shape that extends in the same direction AX as the axis of rotation of servo motor 36, that is, in the direction AX along which the servo motor 36 and the reduction gear 37 are arranged in series (see Fig. 4). The motor control board 41 is arranged so that one side of the board (the side on which the connector 42 is mounted) faces toward the servo motor 36 and the other side faces away from the servo motor 36. The motor control board 41 is fixed (screwed) to the housing 36a of the servo motor 36 through a shield sheet metal 51 (i.e., a board holding sheet metal) made of metal.

The motor control board 41 has a synthetic resin board cover 61 assembled to cover the board surface on the side where the connector 42 is mounted (hereinafter, the board surface will be referred to as a "surface"). This board cover 61 prevents dirt inside the robot body 21 from adhering to the motor control board 41.

The following is a supplemental explanation of not only the assembly structure of the board unit 40 provided with the motor control board 41, the board cover 61, and the shield sheet metal 51 but also the structure of fixing the board unit 40 to the housing 36a.

The board cover 61 has a long plate-shaped flat plate portion 62 facing the motor control board 41 with a gap between such two elements 41 and 62 (see Fig. 5). The flat plate 62 has a leg 63 (sett Fig. 4) protruding from one end of the flat plate 62 (the end on the reduction gear side) toward the motor control board 41 and a boss 64 protruding from the center portion of the flat plate 62 toward the motor control board 41. The tip portion of the leg 63 and the tip portion of the boss 64 contact the surface of the motor control board 41. This avoids contact between the motor control board 41 and the flat plate portion 62.

The foregoing connector 42 is located at the end of the motor control board 41 on the side of the motor control board 41, which is located to be closer to the reduction gear 37. The connector 42 has an insertion slot 43 into which the FPC board 45 can be inserted. This insertion slot 43 has an opening facing the reduction gear 37. The legs 63 of the board cover 61 are located at the respective corners of the motor control board 41 and are aligned in a direction SD which is orthogonal to the insertion direction to the opening of the insertion slot 43, in which the FPC board is inserted via the opening into the insertion slot 43 along the insertion direction. Hence, in the present embodiment, the insertion direction is set to be the same as the direction AX along which the servo motor 36 and the reduction gear 37 are arranged in series.

The area of the board 41 sandwiched by those legs 63 is connected to the insertion slot 43. The legs 63, together with a restrictive member described below, function as walls that restricts or suppresses twisting or other misalignment of the FPC board 45 placed in the area.

Each of the legs 63 have a tip portion. This tip portion is flat and parallel to the motor control board 41. The tip portions (flat portion) and the motor control board 41 overlap in the thickness direction T of the motor control board 41. The shield sheet metal 51 has an engagement portion 52 that engages the overlapped portion. The flat plate portion 62 has the other end (that is, the end opposite to the end on the side where the legs 63 are formed). At this other end, a claw portion 65 is formed so that it protrudes toward the motor control board 41. The claw portion 65 has a tip, which hooks onto the back surface of the motor control board 41, and the foregoing overlapping portion and the engaging portion 52 are engaged with each other. As a result, the lifting motions of the board cover 61 from the motor control board 41 is restricted or prohibited.

An opening (i.e., an opening 66a for the connector) is formed in the flat part 62 to match the connector 42. The connector 42 has a portion which is located in the aperture 66a for the connector. The connector 42 is trapped in the opening 66a for the connector. This restricts positional changes of the board cover 61 in a direction parallel to the board surface of the motor control board 41.

The foregoing configuration prevents the board cover 61 from falling off. The board unit 40 can be attached and detached (e.g., by attaching or removing of screws) in a state the motor control board 41, shield sheet metal 51, and board cover 61 are combined as one member. For this purpose, an insertion slot for tools (e.g., screwdriver) is formed in the flat part 62 of the board cover 61.

In the present embodiment, the motor control board 41, the FPC board 45, the connector 42, the restrictive member 68, and the legs 63 are the essential elements comprising the wiring structure.

Next, the configuration of the connection between the motor control board 41 and the FPC board 45 will now be supplementally explained.

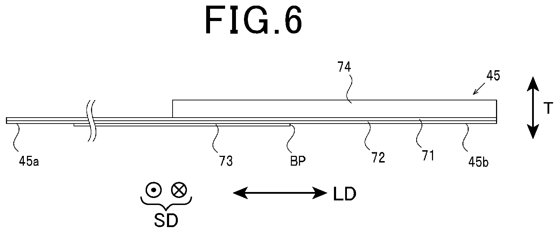

As shown in Fig. 6, the FPC board 45 has a base film layer 71 (specifically, made of polyimide, which serves as ab insulating layer), a conductor layer 72 (specifically, made of copper foil) on one side (surface) of the base film layer 71, and a coverlay film layer 73 (specifically, made of polyimide, which serves as insulating layer). The coverlay film layer 73 (simply cover layer) covers the conductor layer 72 to protect the conductor layer 72. In the conductor layer 72, wiring patterns (equivalent to the foregoing lead wires) are formed to transmit signals from each of the strain gauges 39. Those wiring patterns include the foregoing bridge circuit section and amplifier section.

For the FPC board 45, it is sufficient to have a structure that can transmit signals for strain detection, so that there is no need to necessarily have the bridge circuit section and amplifier section formed the board. For example, the bridge circuit and amplifier section may be provided on the motor control board 41, and the signals from the strain gauge 39 may be inputted to the motor control board 41 through the FPC board 45. A detection board having a configuration equivalent to the bridge circuit or amplifier section may be provided on the reduction gear 37 side, and the signals from the detection board may be inputted to the motor control board 41 through the FPC board 45. Incidentally, it is also possible for the FPC board 45 to include the strain gauge and integrate the sensor function into the FPC board 45.

In the connector 42, a plurality of connection terminals 44 are arranged at the back of the insertion slot 43 described above in the insertion direction. These plurality of connection terminals 44 are arranged in a direction that intersects (orthogonally to) the insertion direction in which the FPC board 45 is inserted, so that the connection terminals 44 are aligned to be side by side in the direction orthogonal to the insertion direction. In the present embodiment, this intersecting orthogonal direction corresponds to the width direction SD of the FPC board 45. In the control-board-side connection part 45b of the FPC board 45, the coverlay film layer 73 is partially cut. In other words, at this partially cut portion, the leading edge of each wiring pattern of the above conductor layer 72 is exposed to the outside. Therefore, the tip end of each of the wiring patterns is configured to function as a terminal in the control-board-side connection part 45b.

The FPC board 45 has a compensating layer 74 (specifically, polyimide: serving as an insulating layer) for thickness compensation provided on the back side of the base film layer 71. This compensating layer 74 is shaped in a flat plate. The compensating layer 74 sets the thickness of the control-board-side connection part 45b to be the same as the size (height) of the insertion slot 43. In other words, the thickness of compensating layer 74 is adjusted to ensure contact between the wiring pattern of FPC board 45 and the connection terminal 44 of the connector 42 (see Figs. 5A and 5B). When the FPC board 45 is inserted to the deep position in the insertion slot 43, the wiring pattern on the FPC board 45 and the connection terminal 44 have a mutual contact (i.e., an electrically conductive state is realized). The compensating layer 74 overlaps the base film layer 71 over the entire width direction SD of the FPC board 45, and is formed in the longitudinal direction LD of the FPC board 45 in a partial area including the tip of the FPC board 45.

A inconvenience that may occur when the coverlay film layer 73 is omitted from the arrangement. If the coverlay film layer 73 is not provided, the strength of the FPC board 45 becomes lower in the area where the conductor layer 72 is exposed, compared to the area where the conductor layer 72 is covered by the coverlay film layer 73 (i.e., flexibility of the FPC board 45 becomes higher). This increases the risk of wire breakage in the wiring pattern of the conductor layer 72. In particular, the thickness of FPC board 45 substantially changes (because it becomes discontinuous) at a step BP positioned between a part where the coverlay film layer 73 is formed and a part where the coverlay film layer 73 is not formed on the control-board-side connection part 45b. In the following, this thickness step BP is referred to a "thickness step BP" which defines a change in the thickness of the FPC board 45 in the longitudinal direction LD thereof.

Thus, if the FPC board 45 is bent or otherwise deformed in the vicinity of the thickness step BP, physical, i.e., electrical disconnection is likely to occur at the thickness step BP.

This inconvenience has been improved in the present embodiment. Practically, the thickness of the compensating layer 74 shown in the present embodiment is greater than the sum of the thicknesses of the base film layer 71 and the coverlay film layer 73. As a result, the strength of the FPC board 45 at least in the area where the compensating layer 74 is formed is higher than that of the FPC board 45 in the area where the compensating layer 74 is not formed. In other words, the compensating layer 74 has a certain reinforcing function, and the FPC board 45 is less likely to flex than the area where the compensating layer 74 is not formed.

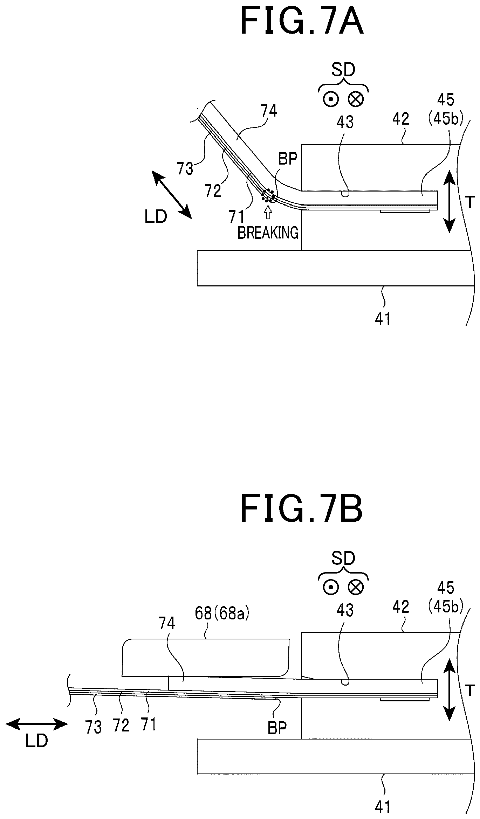

The compensating layer 74 is formed such that the compensating layer 74 overlaps the thickness step BP in the thickness direction T of the FPC board 45. In other words, the compensating layer 74 is formed such that the compensating layer 74 straddles the thickness step BP in the longitudinal direction LD of the FPC board 45. This reduces the risk of wire breakage due to insufficient strength. However, even if the compensating layer 74 provides a certain degree of reinforcement, it is still difficult to eliminate the concern about stress concentration occurring at the thickness step BP when the FPC board 45 bends near the thickness step BP. For example, in the comparative example shown in Fig. 7A, the FPC board 45 is largely bent in the vicinity of connector 42, and this deflection causes disconnection due to stress concentration near the thickness step BP. One of the features of the present embodiment is that it is devised in consideration of this difficulty. The following is an explanation of an improvement in the difficulty.

As shown in Figs. 5A and 5B, when the FPC board 45 is connected to the motor control board 41, the thickness step BP is located outside the insertion slot 43 of the connector 42. The compensating layer 74 has a part which protrudes outward from the insertion slot 43 of the connector 42.

The flat part 62 of the board cover 61 has a range located between the pair of legs 63 in the width direction SD orthogonal to the longitudinal direction LD, which is shown in Fig. 4. The portion of this range extends in the thickness direction T of the FPC board 45 to a position overlapping the compensating layer 74, i.e., to a position on the end side of the connector 42. This extended portion faces the compensating layer 74 with a small gap provided between the extended portion and the compensating layer 74. Hence, when the FPC board 45 is bent such that the FPC board 45 is curved to the back side of the base film layer 71, the extended portion has a function of restricting such deflection by making the FPC board 45 come in contact with the compensating layer 74. Therefore, the extended portion function as a "restrictive member 68".

A window opening 66b is formed in the center of the restrictive member 68, and the control-board-side connection part 45b of the FPC board 45 is exposed outside through this window opening 66b. The control-board-side connection part 45b (in detail, the compensating layer 74) has a marker 79 printed (in detail, silk printed) thereon to confirm whether the FPC board 45 is surely inserted in the proper position (see Fig. 4). The operator can visually check the position of the marker 79 through the window opening 66b, thereby preventing the presence of the restrictive member 68 from interfering with the checking work.

Alternatively, if the compensating layer 74 is transparent, the target of the marker 79 may be changed from the compensating layer 74 to the base film layer 71.

As shown in Fig. 4, the restrictive member 68 is composed of a first restrictive member 68a and a second restrictive member 68b. Of these restrictive members, the first restrictive member 68a is located on both sides of the window opening 66b in the width direction SD of the FPC board 45. Meanwhile, the second restrictive member 68b is configured to connect the tips of both of the first restrictive members 68a at a position on an end side of the window opening 66b, which is closer to the gauge-side connection part 45a, in the removal direction of the FPC board 45.

As shown in Fig. 5A, each of the first restrictive members 68a is formed in the form of a long plate extending in the attachment/detachment direction (i.e., the longitudinal direction LD) of the FPC board 45 so as to straddle the above thickness step BP. Each of the first restrictive members 68a faces the compensating layer 74 on both sides of the thickness step BP in the width direction SD. As shown in Fig. 5B, the second restrictive member 68b is formed as a long plate extending in the width direction SD of the FPC board 45. The second restrictive member 68b faces the compensating layer 74 at a position that is ahead of the thickness step BP in the removal direction of the FPC board 45. According to this configuration, the window opening 66b can be provided to reduce work errors while avoiding the presence of the window opening 66b from interfering with the regulatory function described above.

In the present embodiment, as described, the first and second restrictive members 68a and 68b are used together, but a modified configuration is still possible. It is also possible to have a configuration with either one of the first and second restrictive members 68a and 68b.

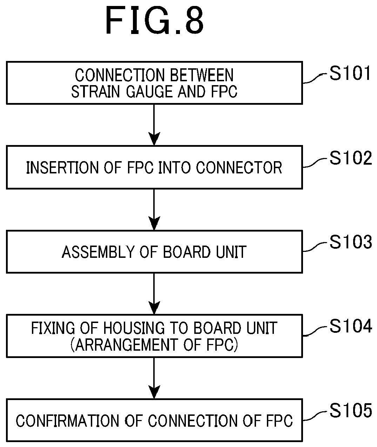

With reference to Figs. 8 and 9, how the FPC board 45 is assembled will now be described. This assembly may be done manually or mechanized by using, for example, an industrial robot.

As shown in Fig. 8, first of all, the strain gauge 39 is connected to the gauge-side connection part 45a of the FPC board 45 (step S101, see Fig. 9A). Next, the control-board-side connection part 45b of the FPC board 45 is inserted into the connector 42 of the motor control board 41 (S102, see Fig. 9B).

In this insertion, since the FPC board 45 is easily deformed, so that the control-board-side connection part 45b, which is relatively less flexible (specifically, the part where the compensating layer 74 is formed), can be pinched with fingers of an operator or an robot, for example. And the pinched control-board-side connection part 45b is inserted into the insertion slot 43 of the connector 42. Hence, this way facilitates the insertion work.

By inserting the FPC board 45 into the connector 42 in this manner, the motor control board 41 and the FPC board 45 are connected.

After the insertion step, the shield sheet metal 51 and the board cover 61 are assembled to the motor control board 41 to form the board unit 40 (S103). As a result, the restrictive member 68 of the board cover 61 faces the compensating layer 74 of the FPC board 45. In this faced state, such members including the claw portion 65 and the engagement portion 52 prevent the board cover 61 from falling off. In addition, when the FPC board 45 bends and hits the above-mentioned restrictive members 68, the restrictive members 68 are able to restrict the bent FPC board 45 from being bent any more. In other words, further bending or deforming motions of the FPC board 45 can be avoided.

Then, the FPC board 45 is passed through the gap between the reduction gear 37 and the servo motor 36 to bypass the reduction gear 37 and other elements, and the board unit 40 is fixed to the housing 36a of the servo motor 36 (step S104, see Fig. 9C). Even if the FPC board 45 is forced to be bent unnecessarily, the restriction function provided by the restrictive member 68 is already in effect. As a result, physical and/or electrical disconnection of the FPC board 45 (especially near the above-mentioned thickness step BP) due to, for example, an operator's work error, can be prevented or reduced.

After the board unit 40 is fixed, it is checked visually or with an optical camera through the window opening 66b of the board cover 61 to see if the foregoing marker 79 (see Fig. 4) is in the proper position (step S105). In this assembly process, when an external force is applied to the FPC BOARD 45, such as by bending the FPC board 45, an insertion allowance of the FPC board 45 which is to be inserted into the insertion slot 43 may become small. Even in such a case occurs, this can be ascertained by this check.

In the present embodiment, the thickness of the FPC board 45 is discontinuous at the thickness step BP between the portion where the conductor layer 72 is covered by the coverlay film layer (cover layer) 73 and the portion where the conductor layer 72 is exposed from the coverlay film layer 73. The degree of deformation may increase locally at the discontinuity in thickness. This is because stress concentration occurs due to the lower strength of the board.

In this respect, in the present embodiment, the compensating layer 74 for the connector is formed across this thickness step BP. The compensating layer 74 substantially increases the thickness of the FPC board 45 and reduces deformation caused near the thickness step BP.

However, even the part where the compensating layer 74 is formed may be deformed by strong force applied during the assembly process of the fFPC board 45. When such deformation occurs, the deformation caused near the thickness step BP may be larger than that of other parts.

Hence, the compensating layer 74 is formed so that the compensating layer 74 protrudes from the insertion slot 43 of the connector 42. Additionally to this protruded configuration, a restrictive member 68 is provided at the position overlapping this protruding portion. When the FPC board 45 is deformed (e.g., bent) and hits the restrictive member 68, further deformation is restricted or prohibited by the restrictive member 68. Therefore, disconnection at the foregoing thickness step BP, i.e., loss of electrical communication function due to disconnection, can be reduced. This allows the robot 10 to enjoy the benefits of using FPC boards (e.g., high-density mounting of various electrical components and miniaturization of the robot) while contributing to improved reliability of the robot 10.

The FPC board 45 shown in this configuration is connected to the motor control board 41 by inserting FPC board 45 into the insertion slot 43 of the connector 42. In such a connecting configuration, the inserted portion of the FPC board 45 may vary due to various factors. In this regard, the restrictive member 68 shown in the present embodiment is formed to straddle the edges of the compensating layer 74. With this configuration, the restricting function can be successfully demonstrated even when the variations in insertion position occur.

By substantially increasing the thickness of the FPC board 45 by employing the compensating layer 74, general-purpose products can be used for the connector 42. In other words, the connection structure can be made common through innovations on the FPC board 45 side, which contributes to reducing the manufacturing cost of robots.

In addition, in the present embodiment, as the "restrictive member," the first restrictive members 68a are provided that extends along both longitudinal edges of the compensating layer 74 in the width direction SD of the FPC board 45. Therefore, deformation of the FPC board 45 can be prevented or suppressed in a well-balanced manner. On the other hand, the FPC board 45 has a designed width in the width direction SD. Therefore, stress concentration may occur in the vicinity of the above thickness step BP due to, for example, twisting of the FPC board 45. In this respect, in the present embodiment, the second restrictive member 68b extending in the width direction SD of the FPC board 45 is provided as one mode of the "restrictive members". This avoids the occurrence of twisting by deflecting the restrictive member 68.

As shown in the present embodiment, the marker 79 is provided on the control-board-side connection part 45b of the FPC board 45. This marker 79 is desirable to avoid connection failures that may occur when the FPC board 45 is inserted insufficiently. Although the provision of the above restrictive member 68 is desirable to protect the FPC board 45, it may be difficult to check the marker 79 at a glance when the restrictive member 68 is located near the connector 42. In this respect, in the present embodiment, the window opening 66b is formed in the flat part 62 surrounded by the first and second restrictive members 68a and 68b. Thus, the marker 79 can be easily checked visually or via an optical camera view through the window opening 66b. This makes it possible to suitably implement the joint installation of the restrictive member 68 and the marker 79.

It is undesirable for the restrictive member 68 to be deformed or displaced by the FPC board 45 when the restrictive member 68 and the FPC board 45 are in mutual contact. Thus, by installing the restrictive member 68 on the board cover 61, which has a certain degree of strength, such an inconvenience can be prevented or reduced from occurring.

Within the body of the robot 15, dirt can occur due to various factors. If such dirt adheres to the motor control board 41, it may cause malfunctions or failures of the robot 15. Therefore, if the motor control board 41 is covered with the board cover 61, occurrent of malfunctions and failures can be reduced effectively. In order to successfully demonstrate the protective function of the board cover 61, it is preferable to cover most of the motor control board 41 with the board cover 61. Therefore, if the above-mentioned restrictive member 68 is installed in such a component, the restrictive member 68 has both the function of covering a part of the motor control board 41 and the function of restricting deformation. Therefore, the space inside the robot 15 can be used more efficiently, compared to a configuration in which the restrictive member 68 and the cover part are provided separately.

### < Modifications>

The present invention will not be limited to the configurations described in the foregoing embodiments, but may be implemented, for example, as follows. Incidentally, each of the following configurations may be applied to the foregoing embodiment, or may be applied to the above embodiment in part or in whole in combination.

In the foregoing embodiment, the restrictive member 68 is provided on the board cover 61, but it is not limited to such a configuration. For example, a configuration corresponding to the restrictive member 68 can be provided on the shield sheet memtal 51, provided on the the housing 36a of the motor control board 41, or the servo motor 36.

In the foregoing embodiment, the factors such as the thickness of the compensating layer 74 and the position of the restrictive member 68 are specified such that a gap is formed between the restrictive member 68 and the compensating layer 74 of the FPC board 45 when the FPC board 45 is in a straight state without being bent. Instead, the factors such as the thickness of the compensating layer 74 and the position of the restrictive member 68 are specified such that, when the FPC board 45 is in a straight state without being bent, the restrictive member 68 and the compensating layer 74 of the FPC board 45 are in contact with each other.

The restrictive member 68 shown in the above embodiment can also be formed to straddle the thickness step portion of the compensating layer 74. For example, the restrictive member 68 may be configured as a linear arrangement or a surface shape arrangement and to extend across the thickness step portion.

In the foregoing embodiment, the pair of first restrictive members 68a are provided on both longitudinal sides in the width direction SD of the FPC board 45, and the second restrictive member 68b is provided to bridge the tips of the first restrictive members 68a. However, the restrictive members 68 are not limited to this configuration. For example, a configuration corresponding to the second restrictive member 68b may be provided to bridge middle portions of the respective first restrictive members 68a.

The window opening 66b shown in the foregoing embodiment is formed such that the marker 79 of the FPC board 45 can be seen when the FPC board 45 and the motor control board 41 are connected with each other. For example, the window opening 66b may be formed to be circular or to be a slit extending in the width direction SD of the FPC board 45. It is also possible to form a notch at the end of the flat part 62 (i.e., the edge closer to the FPC board 45) and make the marker 79 visible through the notch.

In addition, although the window opening 66b is connected to the opening 66a for the connector, these openings 66a and 66b may be provided separately. It is also possible to omit the window opening 66b and connector opening 66a. In particular, if the opening 66a for the connector is omitted, a stopper may be separately provided to prevent the board cover 61 from sliding (falling out), parallel to the board surface of the motor control board 41.

The target to which the board cover 61 is fixed, which is shown in the foregoing embodiment, can be changed to other members. For example, the board cover 61 may be fixed to the shield sheet metal 51 or to the housing 36a of the servo motor 36.

In the foregoing embodiment, the compensating layer 74 and the restrictive member 68 are arranged so as to straddle the thickness step BP of the coverlay film layer 73 in the longitudinal direction. In other words, the restrictive member 68 can be in contact with the compensating layer 74 at positions farther from and closer to the thickness step BP of the coverlay film layer 73 than the thickness step BP of the coverlay film layer 73, compared to the longitudinal position at which the FPC board 45 and the motor control board 41 are connected with each other. At least, it is sufficient if the stress concentration at the abovementioned thickness step BP can be suppressed when the FPC board 45 is deflected. For example, it is possible to arrange the restrictive member 68 closely the thickness step BP.

It is also possible to configure the compensating layer 74 in such a way that the restrictive member 68 can contact the compensating layer 74 at either a position farther or closer than the thickness step BP from or to the foregoing connection position. However, in order to prevent disconnections occurring near the thickness step BP caused by the restrictive member 68, it is preferable to configure the restrictive member 68 to contact the compensating layer 74 at a position farther than the thickness step BP from the connection position.

In the assembly steps shown in the foregoing embodiment, with the motor control board 41 and the FPC board 45 connected with each other, the shield sheet metal 51 and the board cover 61 are assembled to form the board unit 40, and the board unit 40 is then fixed to the housing 36a of the servo motor 36. However, these steps may be modified as follows.

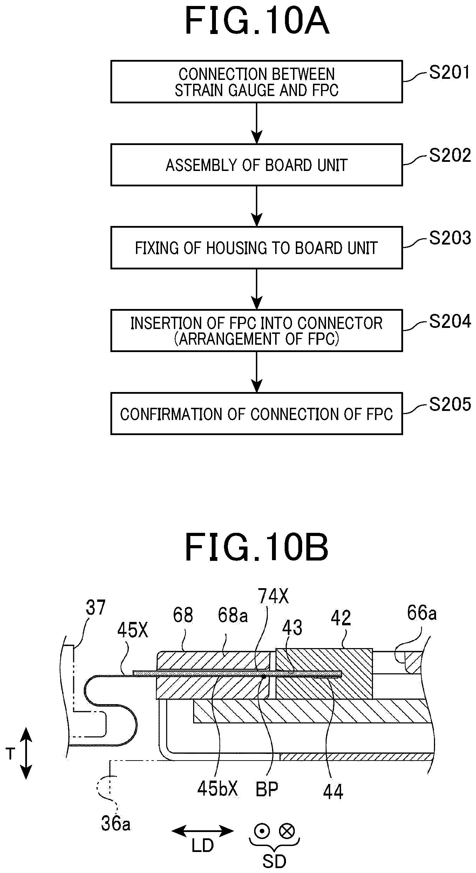

Specifically, as shown in Fig. 10A, the strain gauge 39 and the FPC board 45 are first connected (step S201). Next, the motor control board 41, the shield sheet metal 51, and the board cover 61 are combined to form the board unit 40 (step S202). The board unit 40 is then fixed to the housing 36a of the servo motor 33 (step S203). Further, after the FPC board 45 is positioned to pass through the gap between the reduction gear 37 and the servo motor 36, the FPC board 45 is inserted into the connector 42 (step S204). The connection is confirmed through window opening 66B (step S205).

In other words, as described above, the flow of connecting the motor control board 41 and the FPC BOARD 45 may be done after fixing the motor control board 41. In such work steps, the presence of the restrictive member 68 of the board cover 61 may make it difficult for the operator to complete the insertion of the FPC board 45 while holding the area near the thickness step BP in the FPC board 45. Considering the fact that a large reaction force can be generated when the FPC board 45 hits the back position of the insertion slot 43, it is often difficult to complete the insertion of the FPC board 45 while manually gripping an area of the FPC board 45 around the thickness step BP. Therefore, the technical effect of suppressing stress concentration occurring near the thickness step BP and thereby suppressing wire breakage is beneficial.

Additionally, in the assembly steps according to the foregoing modification, as shown in Fig. 10B, it is also possible to configure an FPC board 45X such that a compensating layer 74X has a part which protrudes more than the the restrictive member 68 in the longitudinal direction LD even when the FPC board 45X is inserted into the back position of the insertion slot 43. In such a configuration, the insertion work can be performed more easily by manually or mechanically grasping the protruded part of the compensating layer 74X.

In the foregoing embodiment, the configuration is adopted which restricts the FPC board 45 from bending (deforming) in the vicinity of the insertion slot 43 of the connector 42 so that the FPC board 45 becomes curved toward the front side of the base film layer 71. In addition to this, the FPC board 45 may be configured to restrict the FPC board 45 from bending (deforming) so that the FPC board 45 has a curve toward the back side of the base film layer 71 in the vicinity of the insertion slot 43.

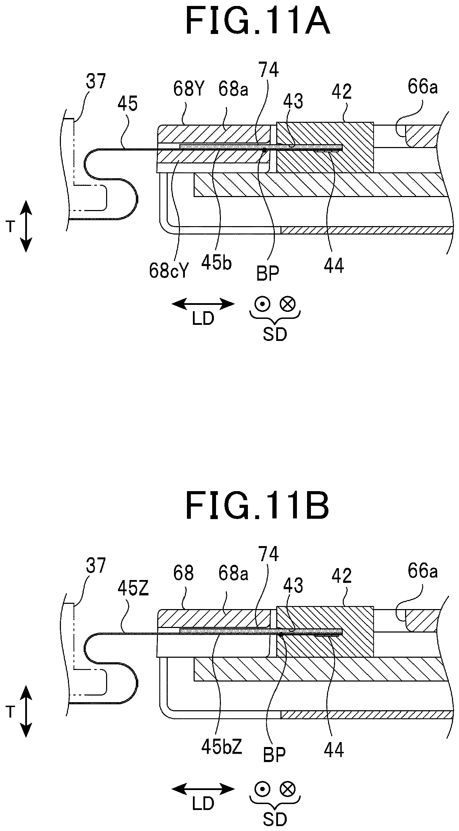

For example, as shown in Fig. 11A, a third restrictive member 68cY is added as part of the restrictive member 68. This third restrictive member 68cY restricts the FPC board 45 from bending (deforming) to be curved toward the back side of the base film layer 71 by contacting the coverlay film layer 73. In this modification, the portion sandwiched between the first restrictive member 68a and the third restrictive member 68cY functions as a guideway to guide the FPC board 45 into the insertion slot 43 of the connector 42. This can, for example, contribute to further simplification of the assembly steps as described.

In the foregoing embodiment, when the FPC board 45 (specifically, the control-board-side connection part 45b) is inserted into the back position of the insertion slot 43, the thickness step BP of the FPC board 45 is positioned outside the insertion slot 43 of the connector 42. Instead, as shown in Fig. 11B, in a state where an FPC board 45Z (specifically, a control-board-side connection part 45bZ) is inserted into the deep position of the insertion slot 43, the thickness step BP of the FPC board 45 is located inside the insertion slot 43.

When inserting the FPC board 45Z into the insertion slot 43 of the connector 42, the thickness of the FPC board 45Z must be smaller than the gap of the insertion slot 43 in the thickness direction T. Thus, a small gap can be created between the FPC board 45Z and the insertion slot 43. Since flexibility is one of the advantages of the FPC board 45, if a large deflection occurs near the entrance of the insertion slot 43, the effect will be felt in the thickness step BP located inside the insertion slot 43.

In view of this situation, it is recommended that the restrictive member 68 be used to suppress deflection not only in a configuration in which the thick step BP is located outside the insertion slot 43, but also in a configuration in which the thick step BP is located inside the insertion slot 43.

In the foregoing embodiment, the wiring structure to prevent disconnection of the FPC board 45 connecting the strain gauge 39 and the motor control board 41 is exemplified. As a modification of this embodiment, a similar wiring structure can be applied to other FPC boards. For example, in a configuration where the rotary encoder 38 and the motor control board 41 are connected by an FPC board, the above wiring structure may also be applied to this FPC board.

Alternatively, the wiring structure for the control-board-side connection part 45b shown in the foregoing embodiment may be applied to the connection part provided between the strain gauge 39 and the gauge-side connection part 45a. In this connection, a connector is provided on the strain gauge 39, and the gauge-side connection part 45a of the FPC board 45 is inserted into this connector. Further, a compensating layer that constitutes the gauge-side connection part 45a and a member that restricts the deflection of the FPC board 45 by contacting the compensating layer may be provided.

In the foregoing embodiment, the FPC board 45 with a single layer of conductor layer 72 is exemplified. Instead, a configuration equivalent to restrictive member 68 can be adopted for an FPC board with multiple layers of conductor layer 72. In this case, disconnection near the thickness step BP can also be reliably prevented or reduced.

As a further modification, the materials of the base layer (film), the coverlay layer (film), and the compensating layer (film) can be arbitrarily set. For example, the coverlay film and the filler plate can be made of PET.

In the foregoing embodiment, the motor control board 41, which is a rigid board, may be configured as a detection board with the bridge circuit sections and the amplifier sections that amplify each signal detected by the bridge circuit sections, and instead, a separate board for motor control may be provided.

Although the foregoing embodiment exemplifies the 6-axis articulated robot, the foregoing connection configuration can also be applied to other articulated robots with 3 to 5 axes, and 7 axes, and so on. It is also possible to apply such connection configuration n to a horizontal articulated robot instead of a vertical articulated robot.

In the foregoing embodiment, industrial robots working in factories are explained as the robot or robot system according to the disclosure. Instead, this is just an example, and the FPC board equipped in the robot or robot system can also be applied to, for example, robots in other fields, robots used in the food industry, service fields, and medical fields.

### <For a group of distinctive features extracted from the foregoing embodiment and modifications>

The following is an explanation of a group of distinctive features which can be extracted or read from the foregoing embodiment, with showing their effects as necessary. For ease of understanding, the corresponding configurations in the embodiment and modifications are shown below in parentheses, as appropriate, but are not limited to such specific configurations shown in parentheses.

### Feature 1:

A distinctive feature 1 is a wiring structure for a robot (15), comprising:
a base layer (base film layer 71),
a cover layer (coverlay film layer 73), and
a flexible printed circuit board (FPC board 45) having a conductor layer (conductor layer 72) provided as a wiring pattern arranged between the base layer (base film layer 71) and the cover layer (coverlay film layer 73). In this structure:
   the flexible printed circuit board (FPC board 45) has a one end part at which the conductor layer (conductor layer 72) is exposed outside from the cover layer (coverlay film layer 73), a connection part (control-board-side connection part 45b) being arranged on the one end part and being connected to a connector (connector 42) of a further electric component (motor control board 41) of the robot (robot 15).

A compensating layer (compensating layer 74) is arranged on the connection part (control-board-side connection part 45b), the compensating layer (compensating layer 74) being subjected to compensation for a thickness of the flexible printed circuit board (FPC board 45), the compensating layer (compensating layer 74) being provided on a part of the base layer which is faced to the conductor layer, the connection part (control-board-side connection part 45b) being partially inserted into an insertion slot (insertion slot 43) of the connector (connector 42).

The compensating layer (compensating layer 74) is formed to bridge a thickness step (thickness step BP) provided between a portion at which the conductor layer (conductor layer 72) is covered by the cover layer (coverlay film layer 73) and a portion at which the conductor layer (conductor layer 72) is exposed from the cover layer (coverlay film layer 73) and to partially protrude from the insertion slot (insertion slot 43) when the connection part (45b) of the flexible printed circuit board (45) is inserted into the insertion slot (43) to electrically connect the connection part (control-board-side connection part 45b) and the connector (connector 42).

The compensating layer (compensating layer 74) having a protruding portion protruded from the insertion slot (insertion slot 43), a restrictive member (restrictive member 68) being provided on the protruding portion so as to overlap with the compensating layer (compensating 74) in a thickness direction (T) of the flexible printed circuit board (FPC board 45), the restrictive member (restrictive member 68) being allowed to touch the compensating layer (compensating layer 74) such that the flexible printed circuit board (FPC board 45) is restricted or suppressed from being deformed.

In the configuration shown in this feature, the thickness of the flexible printed circuit board is discontinuous at the thickness step provided between the portion where the conductor layer is covered by the cover layer and the portion where the conductor layer is exposed from the cover layer. The degree of deformation may increase locally at the discontinuity in thickness. This is because stress concentration occurs due to the lower strength of the board. In this respect, if the compensating layer for the connector is formed across the thickness step, the thickness of the flexible printed circuit board is increased by the compensating layer, deformation caused at the thickness step can be mitigated.

However, it is undeniable that even the part where the compensating layer is formed may be deformed by a stronger force applied during assembly of the flexible printed circuit board, and if such an event occurs, the deformation caused near the thickness step will be larger than in other parts of the board.

In contrast, such a drawback is improved in this feature. The compensating layer shown in this feature is formed so that a part of the compensating layer protrudes from the insertion slot of the connector, and a restrictive member is provided at a position overlapping this protruded portion. When the flexible printed circuit board is deformed (e.g., bent) and hits the restrictive member, further deformation is restricted or suppressed by the restrictive member. Therefore, it is possible to suppress the occurrence of wire breakage at the above-mentioned thickness step, i.e., the loss of electric communication function due to the wire breakage. This contributes to the improvement of robot reliability while enjoying the benefits of employing the flexible printed circuit board according to the present feature (e.g., high-density mounting of various components and downsizing of the robot).

### Feature 2:

In the wiring structure according to feature 1, the restrictive member (68) is located, at least, on both sides of the compensating layer (74) in a width direction (SD) of the flexible printed circuit board (45).

If the restrictive member is located near the edge of the side protruding from the insertion slot along the compensating layer, deformation of the flexible printed circuit board can be efficiently restricted or suppressed. However, in the configuration where the flexible printed circuit board is inserted into the connector as shown in Feature 1, the possibility that the position of the flexible printed circuit board may vary for various reasons cannot be denied. In other words, depending on the state of the flexible printed circuit board assembly, the positional relationship between the restrictive member and the edge of the compensating layer may become inappropriate, and the regulatory function may not be successfully demonstrated.

In this regard, as shown in the present feature, by forming the restrictive member so that it straddles the edge of the compensating layer, the aforementioned positional variation can be tolerated to some extent, and the inconvenience of the restriction function not working properly can be avoided.

### Feature 3:

In the wiring structure according to feature 1 or 2, the restrictive member (68) is bridged to connect both sides of the protruding portion over the compensating layer (74)

The flexible printed circuit board has a certain width. Thus, when the flexible printed circuit board is twisted, stress concentration may occur near the thickness step. However, this problem is solved by this feature. In other words, the restrictive member is formed such that the restrictive member straddles both edges of the flexible printed circuit board in the width direction SD. This makes it easier to suppress the effects of torsion.

### Feature 4:

A feature 4 relates to the wiring structure according to any one of features 1 to 3, in which the respective member is positioned, at least, to overlap, in the thickness direction T, on both ends of the compensating layer in the width direction SD of the flexible printed circuit board.

As shown in this feature, when the restrictive member is positioned to be overlapped on both edges of the compensating layer in the width direction SD, deformation of the flexible printed circuit board can be restricted or suppressed by the restrictive member in a well-balanced manner in the width direction SD.

### Feature 5:

A feature 5 relates to the wiring structure according to any one of features 1 to 4, in which,
the structure includes a maker (the marker 79) used for positionally conforming how the flexible printed circuit board is inserted into the connector, the marker being arranged at the one end part of the flexible printed circuit board, and
the restrictive member has an opening (the window opening 66b) formed therein, thereby making an operator visually confirm the marker.

As shown in this feature, it is preferable to provide the marker at the one end part of the flexible printed circuit board to avoid connection failures due to insufficient insertion of the flexible printed circuit board. Although it is desirable to provide the restrictive member as shown in Feature 1 and other features to protect the flexible printed circuit board, the restrictive member may interfere with visually checking the marker. In this respect, by providing an open portion in the restrictive member to allow visual confirmation of the marker, as shown in this feature, such concerns can be suitably eliminated.

### Feature 6:

A feature 6 relates to the wiring structure according to any one of features 1 to 5, in which the restrictive member is mounted on the electric components for the robot.

The electrical component side for robots, which has a certain degree of strength, may be an object on which the restrictive member is arranged. As a result, even when the restrictive member functions, the restrictive member will not be deformed or displaced by the flexible printed circuit board.

### Feature 7:

A feature 7 relates to the wiring structure according to any one of features 1 to 6, in which the structure includes a base (the shield sheet metal 51) on which the electric components for the robot are mounted and a cover member (the board cover 61) covering the electric components for the robot, and the restrictive member is arranged on, at least, either the base or the cover member.

The base for the robot electrical components and the cover body are configured to have a certain degree of strength. Hence, when such members are chosen as an object on which the restrictive member is arranged, the effect shown in Feature 6 can be more suitably demonstrated.

### Feature 8:

A feature 8 relates to the wiring structure according to any one of features 1 to 7, in which the structure includes a cover member (the board cover 61) coring the electric components for the robot and the restrictive member is arranged on the cover member.

Dirt can be generated in the machine of a robot due to various factors. Such dirt adhering to the electric parts for the robot can cause malfunctions or failures in operations of the robot. Hence, if the electrical parts for the robot are covered by a cover, malfunctions and failures can be reduced. In order to successfully demonstrate the protective function of the cover body, it is desirable to cover a wide area of the electric parts for the robot. Therefore, if the above restrictive member is installed in such a part, the restrictive member has both the function of covering a part of the electric parts for the robot and the function of restricting deformation. This enables more efficient use of the space inside the robot, compared to a configuration in which the restrictive member and the covering part are provided separately. For example, if the electrical components for the robot are mounted on a solid board, it is recommended to place the connector at a distance from the edge of the solid board.

### Feature 9:

A feature 9 relates to an assembly method for assembling the flexible printed circuit board according to feature 7 or 8, the method including:
a first step of connecting the connector of the electrical component for the robot to the connection part of the flexible printed circuit board, and enabling the deformation of the flexible printed circuit board to be restricted by the restrictive member of the cover body, and
a second step of fixing the electrical component for the robot to the fixing part of the robot (the housing 36a of servo motor 36) after the first step.

According to the method shown in this feature, it is possible to prevent or reduce disconnections in the flexible printed circuit board (especially, disconnections at the position of the bord near the thickness step thereof) due to work errors, etc., when fixing electrical components for the robot.

### Feature 10:

A feature 10 relates to an assembly method for assembling the flexible printed circuit board according to feature 7 or 8, the method including:
a step of connecting the connector of the electrical component for the robot to the connecting part of the flexible printed circuit board, and
fixing the electric part for robot is fixed to the fixing part of the robot, after assembling the cover to the electric part for robot to which the flexible printed circuit board is connected.

According to this feature, the electrical component for the robot is fixed after establishing a state in which the flexible printed circuit board can be protected by assembling the cover. This prevents disconnections of the flexible printed circuit board (especially, disconnections at the thickness step of the board) during the fixing process.

### Feature 11:

A feature 11 relates to a robot equipped with the wiring structure according to any one of features 1 to 8.

According to this feature, it is possible to enjoy the benefits of applying, to the robot, especially articulated robot including articulated industrial robots, the foregoing various examples of flexible printed circuit board (e.g., high-density mounting of various components and miniaturization of the robot) while contributing to highly improved robot reliability which results from preventing or reducing occurrence of wire breakage or connection failure during assembly of the flexible printed circuit board for the robot.

### [Brief descriptions of partial reference signs list]

15... Robot (Industrial robot)
35...Motor unit
36...Servo motor
36a: Housing as a fixing part
37... Reduction gear
39...Strain gauge
40... Board unit
41... Motor control board
42...Connector functioning as part of wiring structure
43...Insertion slot
45...FPC board (flexible printed circuit board) functioning as part of wiring structure
45b...Control-board-side connection part as connection part
51 ... Shield sheet metal as base
61...Board cover
62... Flat plate portion,
66b...Window opening as open portion, functioning as part of wiring structure
68...Restricting portion functioning as part of wiring structure
68a...First restricting portion
68b...Second restricting portion
71...Base film layer functioning as part of wiring structure
72...Conductor layer functioning as part of wiring structure
73...Coverlay film layer functioning as part of wiring structure
74...Compensating layer functioning as part of wiring structure
79... Marker functioning as part of wiring structure
BP...Thickness step functioning as part of wiring structure

## Claims

1. A wiring structure for a robot (15), comprising:
a base layer (71),
a cover layer (73), and
a flexible printed circuit board (45) having a conductor layer (72) provided as a wiring pattern arranged between the base layer (71) and the cover layer (73),
wherein
the flexible printed circuit board (45) has a one end part at which the conductor layer (72) is exposed outside from the cover layer (73), a connection part (45b) being arranged on the one end part and being connected to a connector (42) of a further electric component of the robot (15);
a compensating layer (74) is arranged on the connection part (45b), the compensating layer (74) being subjected to compensation for a thickness of the flexible printed circuit board (45), the compensating layer (74) being provided on a part of the base layer which is faced to the conductor layer, the connection part (45b) being partially inserted into an insertion slot (43) of the connector (42);
the compensating layer (74) is formed to bridge a thickness step (BP) provided between a portion at which the conductor layer (72) is covered by the cover layer (73) and a portion at which the conductor layer (72) is exposed from the cover layer (73) and to partially protrude from the insertion slot (43) when the connection part (45b) of the flexible printed circuit board (45) is inserted into the insertion slot (43) to electrically connect the connection part (45b) and the connector (42); and
the compensating layer (74) having a protruding portion protruded from the insertion slot (43), a restrictive member (68) being provided on the protruding portion so as to overlap with the compensating layer (74) in a thickness direction (T) of the flexible printed circuit board (45), the restrictive member (68) being allowed to touch the compensating layer (74) such that the flexible printed circuit board (45) is restricted from being deformed.

2. The wiring structure for the robot (15) according to claim 1, wherein the restrictive member (68) is located, at least, on both sides of the compensating layer (74) in a width direction (SD) of the flexible printed circuit board (45).

3. The wiring structure for the robot (15) according to claim 1, wherein the restrictive member (68) is bridged to connect both sides of the protruding portion over the compensating layer (74).

4. A robot comprising the wiring structure according to one of the claims 1 to 3.
